# EUROPÄISCHE PATENTANMELDUNG

(11) **EP 3 330 722 A1**
(43) Veröffentlichungstag der Anmeldung: **06.06.2018**
(21) Anmeldenummer: 16201731.3
(22) Anmeldetag: 01.12.2016
(51) Int. Cl.: G01R 19/175, G01R 21/06, G01R 31/02, G01R 31/26, G01R 19/15, G01R 21/00

(54) **VERFAHREN UND SCHALTUNG ZUR DIAGNOSE EINES THYRISTOR-LASTSTROMS AUF BASIS DES GATESTROMS**

(71) Anmelder: Siemens Aktiengesellschaft, 80333 München (DE)
(72) Erfinder: Holtz, Stefan, 04277 Leipzig (DE)

(57) **Zusammenfassung**

Die Erfindung betrifft ein Verfahren zur Diagnose eines Laststromes durch eine Last (L), wobei über einen Wechselstromschalter (T2) mit einem Steuereingang (G) durch Anlegen einer Steuerspannung (U_{G}) an den Steuereingang (G) eine Wechselspannung (L1) an die Last (L) geschaltet wird und dadurch der Laststrom durch die Last (L) fließt, wobei ein Stromerkennungsmittel (N1) verwendet wird, welches einen Stromfluss in den Steuereingang (G) bzw. aus den Steuereingang (G) in Form eines Stromimpulses (41) detektiert, und ausgewertet wird, ob bei angelegter Steuerspannung (U_{G}) weiterhin Stromimpulse (41) detektiert werden, wobei für den Fall, dass die Steuerspannung (U_{G}) anliegt und Stromimpulse (41) detektiert werden, dies als ein Beleg für einen Stromfluss durch die Last (L) gewertet wird.

## Beschreibung

Die Erfindung betrifft ein Verfahren zur Diagnose eines Laststromes durch eine Last, wobei über einen Wechselstromschalter mit einem Steuereingang durch Anlegen einer Steuerspannung an den Steuereingang eine Wechselspannung an die Last geschaltet wird und dadurch der Laststrom durch die Last fließt.

Des Weiteren betrifft die Erfindung eine Schaltungsanordnung zur Diagnose eines Laststromes, umfassend ein Steuermittel mit einem Steuerausgang zur Ansteuerung eines Wechselstromschalters, der Wechselstromschalter weist einen ersten Anschluss für das Anschließen einer Wechselspannung, einen zweiten Anschluss für das Anschließen einer Last und einen Steuereingang auf, wobei der Steuereingang mit dem Steuerausgang in Verbindung steht.

Auch betrifft die Erfindung eine Ausgabebaugruppe für die industrielle Prozessautomatisierung zur Ausgabe einer einstellbaren Ausgabespannung für eine Last.

Aufgabe der vorliegenden Erfindung ist es, ein Verfahren zur Diagnose eines Laststromes durch eine Last bereitzustellen, wobei für die Diagnose nicht direkt in den Laststrom eingegriffen werden soll.

Die Aufgabe wird für das eingangs genannte Verfahren dadurch gelöst, dass ein Stromerkennungsmittel verwendet wird, welches einen Stromfluss in den Steuereingang bzw. aus den Steuerausgang in Form eines Stromimpulses detektiert, und ausgewertet wird, ob bei angelegter Steuerspannung weiterhin Stromimpulse detektiert werden, wobei für den Fall, dass die Steuerspannung anliegt und Stromimpulse detektiert werden, dies als ein Beleg für einen Stromfluss durch die Last gewertet wird.

Der der Erfindung zugrundeliegende Mechanismus ist die Erkennung eines Laststrom-Nulldurchgangs am Steuereingang des Wechselstromschalters. Realisiert wird mit dieser Erfindung eine einfache und robuste Erkennung eines Einschaltimpulses des Wechselstromschalters, mit der indirekt auf einen Stromfluss in der Last bzw. in einem Lastkreis geschlossen werden kann.

Im Zusammenhang mit der Erfindung wird als Nulldurchgang der Zeitpunkt bezeichnet, an dem ein Spannungs- oder Stromverlauf den Betrag Null hat.

In einer weiteren Ausgestaltung der Erfindung wird mit dem Verfahren für eine weitere Diagnose zur Erkennung eines Nulldurchgangs der Wechselspannung ein Nulldurchgangs-Erkennungsmittel verwendet, weiterhin wird mit der Detektion eines Stromimpulses auf einen Nulldurchgang des Laststromes geschlossen und aus dem Nulldurchgang des Laststromes und dem Nulldurchgang der Wechselspannung wird eine Phasenverschiebung zwischen dem Laststrom und der Wechselspannung und damit ein Leistungsfaktor der Last bestimmt. Durch die Detektion eines Stromimpulses an dem Wechselstromschalter, insbesondere durch die Detektion eines Ansteuerstromes bei Ausgestaltung des Wechselstromschalters als Thyristor/Triac, ist es möglich, indirekt, und damit verlust- und aufwandsarm auf einen vorhandenen Laststrom zu schließen. Ein Stromfluss im Ansteuerkreis, also im Steuereingang, kann damit qualitativ und zeitlich erfasst werden um damit zu Detektieren, ob und zu welchem Zeitpunkt der Wechselstromschalter bzw. der Thyristor/Triac aktiviert wird und ein Laststrom fließt.

Verfahrensgemäß ist es weiterhin vorteilhaft, wenn das Anlegen der Steuerspannung in ein Zeitintervall gelegt wird, welches sich aufgrund der Kenntnis in welchem Zeitintervall der Wechselstromschalter sich in einen Durchlasszustand befindet, und in diesem Durchlasszustand der Wechselstromschalter nicht angesteuert werden muss, von dem Intervall im Durchlasszustand unterscheidet, um eine Reduzierung einer Ansteuerleistung zu erreichen. Das bedeutet, eine Leistung, die für die Ansteuerung eines Thyristors/Triacs benötigt wird, kann verringert werden, in dem die Ansteuerung nur für die wirklich notwendige Zeit aktiviert wird.

Die eingangs genannte Aufgabe wird ebenso durch eine Schaltungsanordnung zur Diagnose eines Laststromes, umfassend ein Steuermittel mit einem Steuerausgang zur Ansteuerung eines Wechselstromschalters, der Wechselstromschalter weist einen ersten Anschluss für das Anschließen einer Wechselspannung, einen zweiten Anschluss für das Anschließen einer Last und einen Steuereingang auf, wobei der Steuereingang mit dem Steuerausgang in Verbindung steht, dadurch gelöst, dass ein Stromerkennungsmittel vorhanden ist, welches ausgestaltet ist, einen Stromfluss in den Steuereingang bzw. aus den Steuereingang in Form eines Stromimpulses zu detektieren, dabei weist das Stromerkennungsmittel einen Detektionsausgang auf, welcher mit einen Detektionseingang des Steuermittels in Verbindung steht, dabei ist das Steuermittel weiterhin dazu ausgestaltet, auszuwerten, ob bei angelegter Steuerspannung weiterhin Stromimpulse detektiert werden, wobei für den Fall, dass die Steuerspannung anliegt und Stromimpulse detektiert werden, dies ein Beleg für einen Stromfluss durch die Last ist. Es ist nun möglich, eine einfache Diagnose für eine Laststromerkennung zu realisieren. Kontrolliert von dem Steuermittel wird der Wechselstromschalter angesteuert. Dieser Wechselstromschalter, beispielsweise ein Triac oder kombinierte Thyristoren, benötigt aufgrund seiner Halbleiterstruktur nur einen kurzzeitigen Steuerstrom, der zu Null wird, sobald der Leitungspfad mit Ladungsträgern geflutet ist. Der Steuerstrom wird dann solange nicht benötigt, wie die Ladungsträger im Wechselstromschalter vorhanden sind. Versiegt der Laststrom im Wechselstromschalter und sind alle Ladungsträger aus der leitfähigen Region ausgeräumt, sperrt dieser, wenn kein erneuter Steuerstrom zugeführt wird. Dies passiert automatisch jedes Mal, wenn bei einem Nulldurchgang des Laststromes sich die Stromrichtung im Wechselstromschalter umkehrt, der Strom kommutiert. Ist die Ansteuerung des Wechselstromschalters während der Kommutierung aktiv, fließt ein kurzzeitiger Steuerstrom in den Steuereingang des Wechselstromschalters und dieser bleibt leitend. Dieser kurzzeitige Steuerstrom oder auch Stromimpuls kann detektiert werden und mit dieser Detektion kann eine Aussage darüber getroffen werden, ob ein Laststrom fließt.

In einer weiteren Ausgestaltung der Schaltungsanordnung ist für eine weitere Diagnose ein Nulldurchgangserkennung-Mittel vorhanden, dass Nulldurchgangserkennungs-Mittel ist ausgestaltet einen Nulldurchgang der Wechselspannung zu erkennen und dem Steuermittel dies mitzuteilen, wobei das Steuermittel weiterhin dazu ausgestaltet ist, bei Vorliegen eines Stromimpulses am Detektionseingang auf einen Nulldurchgang des Laststromes zu schließen und aus dem Nulldurchgang des Laststromes und dem Nulldurchgang der Wechselspannung eine Phasenverschiebung zwischen Strom und Spannung und damit einen Leistungsfaktor der Last zu bestimmen. Nun kann zum einen der Nulldurchgang des Laststromes und zum anderen der Nulldurchgang der Wechselspannung ermittelt werden. Phasenverschobene Nulldurchgänge treten beispielsweise bei komplexen Lasten (R,L,C) auf. Bei der Ansteuerung von reaktiven Lasten, die eine Phasenverschiebung zwischen Spannung und Strom erzeugen, kann es notwendig sein, einen Ansteuerwinkel anzupassen, um eine vorgegebene Abgabeleistung auch tatsächlich zu erreichen. Diese Anpassung kann von dem Steuermittel unter Einberechnung der bestimmten Phasenverschiebung vorgenommen werden. Mit der bestimmten Phasenverschiebung kann eine gezielte Leistungssteuerung durch Anpassung der Ansteuerkennlinie für die Schaltungsanordnung, beispielsweise eine Phasenanschnittssteuerung, realisiert werden.

In einer weiteren Ausgestaltung ist im Hinblick auf eine Energieeinsparung das Steuermittel dazu ausgestaltet, die Ansteuerung des Wechselstromschalters in ein Zeitintervall zu legen, welches sich aufgrund der Kenntnis im welchem Zeitintervall der Wechselstrom sich in einen Durchlasszustand befindet und in diesem Durchlasszustand der Wechselstrom nicht angesteuert werden muss, von dem Intervall im Durchlasszustand unterscheidet, um eine Reduzierung einer Ansteuerleistung zu erreichen.

Eine besondere Ausgestaltungsform der Schaltungsanordnung sieht vor, dass das Stromerkennungsmittel als ein Optokoppler und der Wechselstromschalter als ein Triac ausgestaltet ist, wobei der Steuerausgang an einen Steuereingang eines Photo-Triacs, der erste Anschluss an einer ersten Hauptelektrode des Photo-Triacs, ein erster Anschluss des Optokopplers an einer zweiten Hauptelektrode des Photo-Triacs und ein zweiter Anschluss des Optokopplers an den Steuereingang angeschlossen ist.

Weiterhin betrifft die Erfindung eine Ausgabebaugruppe für die industrielle Prozessautomatisierung zur Ausgabe einer einstellbaren Ausgabespannung für eine Last, aufweisend eine Schaltungsanordnung, wie zuvor beschrieben.

In einer besonderen Ausgestaltung der Ausgabebaugruppe weist diese Mittel auf, die das Vorliegen eines Drahtbruchs an ein übergeordnetes Automatisierungssystem weiterleiten, dabei ist das Steuermittel weiterhin dazu ausgestaltet, dass Ansteuern des Steuerausgangs und das Vorhandensein eines Nulldurchgangs am ersten Eingang unter Auswertung des Detektionsausgangs dahingehend auszuwerten, dass bei Ausbleiben eines Signals am Detektionsausgang ein Drahtbruch in einer Last in einer Anschlussleitung zur Last vorliegt.

Mit einer derartigen Baugruppe, insbesondere mit der zuvor genannten Schaltungsanordnung, ist es unter Einsatz der indirekten Detektion des Laststromes nun auch möglich, durch Einsatz eines platzsparenden Bauteils bzw. den Stromerkennungsmittel und durch ein Umprogrammieren des Steuermittels auf eine einfache Art und Weise eine Drahtbrucherkennung zu realisieren.

Die Erfindung wird nachstehend anhand der in der Zeichnung näher dargestellten Ausführungsbeispiele näher erläutert. Es zeigen:
- FIG 1: das grundlegende Prinzip einer indirekten Detektion eines Laststromes mit einer einfachen Schaltungsanordnung,
- FIG 2: eine erweiterte Schaltungsanordnung zur Ausgabe einer einstellbaren Ausgabespannung für eine Last mit einem Stromerkennungsmittel,
- FIG 3: Signalverläufe von Strom und Spannung bei einer induktiven Last,
- FIG 4: ein Diagramm zur Darstellung der tatsächlichen Leistungsabgabe des Ausgangs, am Beispiel einer vorgegebenen Leistungsabgabe von 50% und Ansteuerung auf Basis des Spannungsverlaufs, ohne Berücksichtigung der Phasenverschiebung zwischen Spannung und Strom und
- FIG 5: eine Ausgabebaugruppe für die industrielle Prozessautomatisierung.

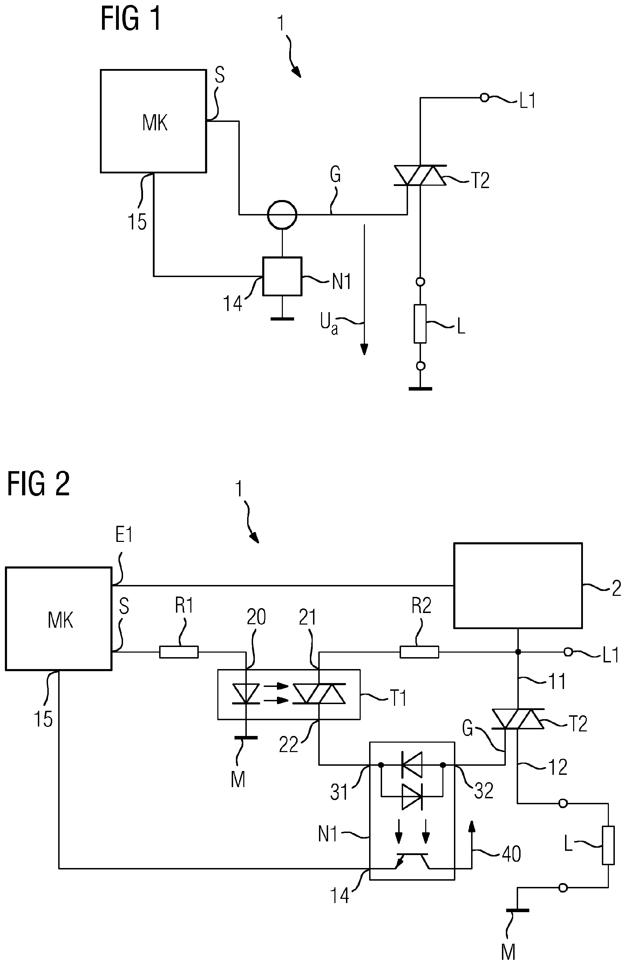

Gemäß der FIG 1 ist eine Schaltungsanordnung 1 zur Diagnose eines Laststromes durch eine Last L dargestellt. Ein Steuermittel MK, beispielsweise ein Mikrocontroller, mit einem Steuerausgang S zur Ansteuerung eines Wechselstromschalters T2, steht mit einem Steuereingang G des Wechselstromschalters T2 in Verbindung. Der Wechselstromschalter T2 liegt in Reihe mit der Last L an einer Wechselspannung L1. Durch ein Stromerkennungsmittel N1, welches ausgestaltet ist, einen Stromfluss in den Steuereingang G bzw. aus den Steuereingang G in Form eines Stromimpulses 41 zu detektieren, ist es möglich, indirekt auf einen Laststrom durch die Last L zu schließen.

Dabei weist das Stromerkennungsmittel N1 einen Detektionsausgang 14 auf, welcher mit einen Detektionseingang 15 des Steuermittels MK in Verbindung steht. Das Steuermittel MK ist dazu ausgestaltet, auszuwerten, ob bei angelegter Steuerspannung U_{G} weiterhin Stromimpulse 41 detektiert werden, wobei für den Fall, dass die Steuerspannung U_{G} anliegt und Stromimpulse 41 detektiert werden, dies ein Beleg für einen Stromfluss durch die Last L ist. Durch die Detektion des Ansteuerstromes, beispielsweise eines Thyristors/Triacs ist es möglich, indirekt und damit verlust- und aufwandsarm auf einen vorhandenen Laststrom zu schließen. Der Vorteil der vorgeschlagenen Lösung besteht darin, dass ein bisher nicht genutzter, aus dem inneren Aufbau eines Thyristors/Triacs resultierender Effekt, ausgenutzt wird. Wird bei einem an Wechselspannung betriebenen Thyristor/Triac ein Nulldurchgang im Laststrom durchlaufen, so lässt sich das am mit Spannung angesteuerten Steuereingang G durch einen kurzzeitig erhöhten Stromfluss in den Steuereingang G erkennen. Die Erkennung eines Laststromnulldurchgangs am Steuereingang G ist der der Erfindung zugrundeliegende Mechanismus.

Hieraus ergeben sich viele nutzbringende Vorteile gegenüber einer bisher üblichen Erfassung von Nulldurchgängen durch z.B. einen Shunt im Lastkreis. Die Vorteile sind
- im Lastkreis fällt keine zusätzlichen Verlustleistung an,
- eine Nulldurchgangserkennung erfolgt auf einer Steuerspannungsseite mit einem geringem Spannungspegel und getrennt von einem Lastkreis nahezu verlustleistungslos,
- sonst erforderliche Koppler können entfallen,
- eine erforderliche Auswerteelektronik ist einfach und kostengünstig,
- es ist eine einfache Bestimmung des Phasenwinkels zwischen Spannung und Strom möglich,
- komplexe Lasten können optimal angesteuert werden.

Gemäß FIG 2 ist eine erweiterte Schaltungsanordnung 1 dargestellt, neben dem Steuermittel MK mit seinem Steuerausgang S zur Ansteuerung des Wechselstromschalters T2 und dem Stromerkennungsmittel N1 ist jetzt auch ein Nulldurchgangserkennungs-Mittel 2 für einen Nulldurchgang der angeschlossenen Wechselspannung L1 vorhanden. Der Wechselstromschalter T2 ist als ein Triac ausgestaltet, kann aber auch aus kombinierten Thyristoren bestehen. Der Wechselstromschalter T2 weist einen ersten Anschluss 11 und einen zweiten Anschluss 12 und einen Steuereingang G auf. Bei einer Ausgestaltung des Wechselstromschalters T2 als ein Triac, würde der Steuereingang G dem Gateeingang eines Triacs entsprechen und der erste Anschluss 11 einer ersten Hauptelektrode des Triacs und der zweite Anschluss 12 einer zweiten Hauptelektrode des Triacs. Der Triac liegt zwischen einem Anschluss für eine Wechselspannung L1 in Reihe mit der Last L, welche letztendlich an einen Massepunkt M angeschlossen ist. Wird der Triac derart angesteuert, dass er leitend ist, so kann ein Laststrom durch die Last L fließen. Das Nulldurchgangs-Erkennungsmittel 2 ist an dem ersten Anschluss 11 angeschlossen um Spannungsnulldurchgänge zu erkennen und an das Steuermittel MK weiterzuleiten. Für das entgegennehmen von erkannten Nulldurchgängen der Wechselspannung L1 weist das Steuermittel MK einen ersten Eingang E1 auf. Der Steuereingang G wird wie folgt angesteuert: Über einen Steuerausgang S des Steuermittels MK und einem ersten Widerstand R1 gelangt ein Ansteuersignal zu einem Steuereingang 20 eines Photo-Triacs T1. Die Leuchtdiode des Photo-Triacs T1 leuchtet und gibt dem eigentlichen Thyristor des Photo-Triacs T1 frei. Eine erste Hauptelektrode 21 des Photo-Triacs T1 ist über einen zweiten Widerstand R2 mit der Wechselspannung L1 verbunden. Eine zweite Hauptelektrode 22 des Photo-Triacs ist mit einem ersten Anschluss 31 des Stromerkennungsmittels M1 bzw. des Optokopplers verbunden. Ein zweiter Anschluss 32 des Stromerkennungsmittels N1 ist mit dem Steuereingang G des Triacs T2 verbunden und kann diesen mit einem entsprechenden Steuerstrom freischalten.

Fließt ein Steuerstrom, auch wenn es nur ein kurzer Impuls ist, so wird dieser durch das Stromerkennungsmittel N1 erkannt und kann über einen Detektionsausgang 14, welcher angeschlossen ist an einen Detektionseingang 15 des Steuermittels MK, dem Steuermittel MK mitteilen, dass der Triac einen Steuerstrom erhalten hat. Zur Signalgenerierung des Stromerkennungsmittel N1 ist dieses an einer Signalspannung 40 angeschlossen.

Kontrolliert von dem Steuermittel MK wird der Triac vom Photo-Triac T1 angesteuert. Der Triac benötigt aufgrund seiner Halbleiterstruktur nur einen kurzzeitigen Steuerstrom, der zu Null wird, sobald der Leitungspfad mit Ladungsträgern geflutet ist. Der Steuerstrom wird dann solange nicht benötigt, wie Ladungsträger im Triac vorhanden sind. Versiegt der Laststrom im Triac und sind alle Ladungsträger aus der leitfähigen Region ausgeräumt, so sperrt dieser, wenn kein erneuter Steuerstrom zugeführt wird. Der Optokoppler detektiert den Steuerstrom und das Steuermittel MK kann mit diesem Signal feststellen, ob ein Laststrom fließt und erfasst damit auch den genauen Zeitpunkt des Stromnulldurchgangs.

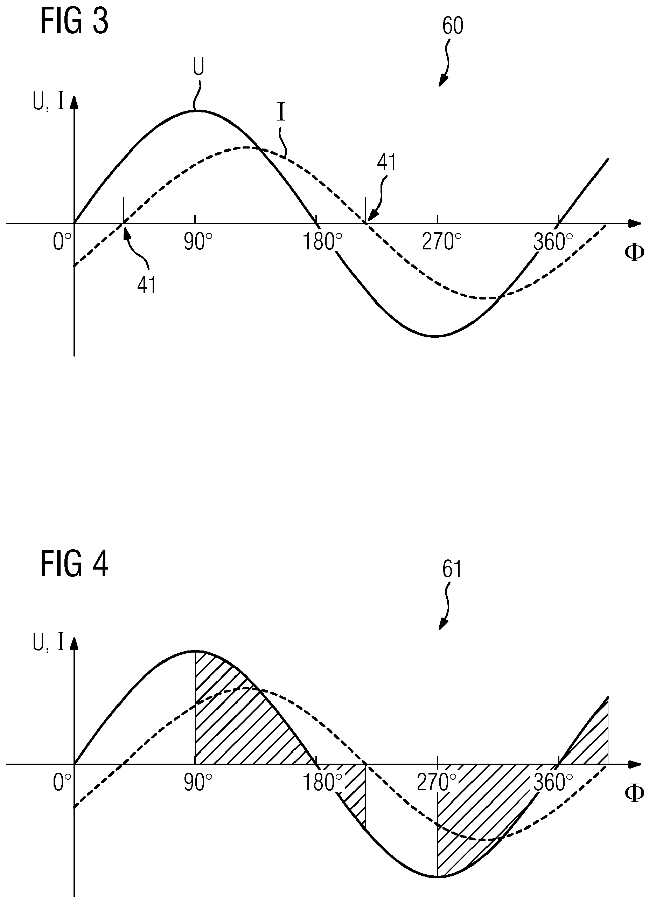

FIG 3 zeigt die typischen Signalverläufe 60 von Strom I und Spannung U bei der Schaltungsanordnung nach FIG 1 mit einer induktiven Last L und dauerhafte Ansteuerungen des Triacs. Durch die induktive Last L ist der Laststrom gegenüber der Lastspannung verzögert. An den Stellen, wo der Stromverlauf des Stromes I einen Nulldurchgang aufweist, sind Stromimpulse 41 eingezeichnet, welche das Ansteuern des Triacs bei Zündung bzw. bei Stromrichtungsumkehr symbolisieren.

Mit der FIG 4 ist ein Diagramm 61 zur Darstellung der tatsächlichen Einschaltzeit des Triacs abgebildet. Straffiert dargestellt ist der Bereich der tatsächlichen Leistungsabgabe an der Last L, bei einer gewünschten Leistungsabgabe von 50%, auf Basis des Spannungsverlaufs und ohne dass die Phasenverschiebung zwischen Strom und Spannung bei der Ansteuerung berücksichtigt wurde.

Das Diagramm 61 zeigt, dass eine Ansteuerkennlinie des Triacs bei Phasenverschiebung angepasst werden muss, um die vom Anwender vorgegebenen Leistungsabgabe auch tatsächlich zu erreichen. Diese Anpassung kann durch Einberechnung der aufgrund der detektierten Stromimpulse bestimmten Phasenverschiebung vom dem Steuermittel MK vorgenommen werden.

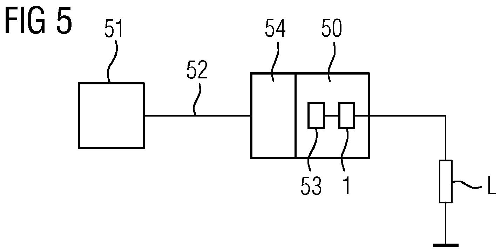

Mit der FIG 5 ist eine Ausgabebaugruppe 50 für die industrielle Prozessautomatisierung zur Ausgabe einer einstellbaren Ausgabespannung für eine Last dargestellt. Die Ausgabebaugruppe 50 ist an ein Interfacemodul angeschlossen. Das Interfacemodul 54 ist über einen Feldbus 52 mit einem übergeordneten Automatisierungssystem 51 verbunden. Die Ausgabebaugruppe 50 beinhaltet die Schaltungsanordnung 1 nach FIG 2 und kann dementsprechend die Last L steuern. Weiterhin weist die Ausgabebaugruppe 50 ein Meldemittel 53 auf. Signalisiert der Mikrocontroller MK der Schaltungsanordnung 1 das ein Drahtbruch vorliegt, so wird das dem Meldemittel 53 mitgeteilt, welches über das Interfacemodul 54 und dem Feldbus 52 dies dem übergeordneten Automatisierungssystem 51 mitteilt.

## Patentansprüche

1. Verfahren zur Diagnose eines Laststromes durch eine Last (L), wobei über einen Wechselstromschalter (T2) mit einem Steuereingang (G) durch Anlegen einer Steuerspannung (U_{G}) an den Steuereingang (G) eine Wechselspannung (L1) an die Last (L) geschaltet wird und dadurch der Laststrom durch die Last (L) fließt, **dadurch gekennzeichnet, dass** ein Stromerkennungsmittel (N1) verwendet wird, welches einen Stromfluss in den Steuereingang (G) bzw. aus den Steuereingang (G) in Form eines Stromimpulses (41) detektiert, und ausgewertet wird, ob bei angelegter Steuerspannung (U_{G}) weiterhin Stromimpulse (41) detektiert werden, wobei für den Fall, dass die Steuerspannung (U_{G}) anliegt und Stromimpulse (41) detektiert werden, dies als ein Beleg für einen Stromfluss durch die Last (L) gewertet wird.

2. Verfahren nach Anspruch 1, wobei für eine weitere Diagnose zur Erkennung eines Nulldurchgangs der Wechselspannung (L1) ein Nulldurchgangserkennungs-Mittel (2) verwendet wird, weiterhin wird mit der Detektion eines Stromimpulses (41) auf einen Nulldurchgang des Laststromes geschlossen und aus dem Nulldurchgang des Laststromes und dem Nulldurchgang der Wechselspannung (L1) wird eine Phasenverschiebung zwischen dem Laststrom und der Wechselspannung (L1) und damit ein Leistungsfaktor der Last (L) bestimmt.

3. Verfahren nach einem der Ansprüche 1 oder 2, wobei das Anlegen der Steuerspannung (U_{G}) in ein Zeitintervall gelegt wird, welches sich aufgrund der Kenntnis in welchem Zeitintervall der Wechselstromschalter (T2) sich in einem Durchlasszustand befindet und in diesem Durchlasszustand der Wechselstromschalter nicht angesteuert werden muss, von dem Intervall im Durchlasszustand unterscheidet, um eine Reduzierung einer Ansteuerleistung zu erreichen.

4. Schaltungsanordnung (1) zur Diagnose eines Laststromes, umfassend ein Steuermittel (MK) mit einem Steuerausgang (S) zur Ansteuerung eines Wechselstromschalters (T2), der Wechselstromschalter (T2) weist einen ersten Anschluss (11) für das Anschließen einer Wechselspannung (L1), einen zweiten Anschluss (12) für das Anschließen einer Last (L) und einen Steuereingang (G) auf, wobei der Steuereingang (G) mit dem Steuerausgang (S) in Verbindung steht,
**dadurch gekennzeichnet, dass** ein Stromerkennungsmittel (N1) vorhanden ist, welches ausgestaltet ist einen Stromfluss in den Steuereingang (G) bzw. aus den Steuereingang (G) in Form eines Stromimpulses (41) zu detektieren, dabei weist das Stromerkennungsmittel (N1) einen Detektionsausgang (14) auf, welcher mit einem Detektionseingang (15) das Steuermittel (MK) in Verbindung steht, dabei ist das Steuermittel (MK) weiterhin dazu ausgestaltet auszuwerten, ob bei angelegter Steuerspannung (U_{G}) weiterhin Stromimpulse (41) detektiert werden, wobei für den Fall, dass die Steuerspannung (U_{G}) anliegt und Stromimpulse (41) detektiert werden, dies ein Beleg für einen Stromfluss durch die Last (L) ist.

5. Schaltungsanordnung (1) nach Anspruch 4, wobei für eine weitere Diagnose ein Nulldurchgangserkennungs-Mittel (2) vorhanden ist, das Nulldurchgangserkennungs-Mittel (2) ist ausgestaltet einen Nulldurchgang der Wechselspannung (L1) zu erkennen und dem Steuermittel (MK) dies mitzuteilen, wobei das Steuermittel (MK) weiterhin dazu ausgestaltet ist bei Vorliegen eines Stromimpulses (41) am Detektionseingang (15) auf einen Nulldurchgang des Laststroms zu schließen und aus dem Nulldurchgang des Laststromes und dem Nulldurchgang der Wechselspannung (L1) eine Phasenverschiebung zwischen Strom und Spannung und damit einen Leistungsfaktor der Last (L) zu bestimmen.

6. Schaltungsanordnung (1) nach einem der Ansprüche 4 bis 5, wobei das Steuermittel (MK) weiterhin dazu ausgestaltet ist die Ansteuerung des Wechselstromschalters (T2) in einen Zeitintervall zu legen, welches sich aufgrund der Kenntnis in welchem Zeitintervall der Wechselstromschalter (T2) sich in einem Durchlasszustand befindet und in diesem Durchlasszustand der Wechselstromschalter nicht angesteuert werden muss, von dem Intervall im Durchlasszustand unterscheidet, um eine Reduzierung einer Ansteuerleistung zu erreichen.

7. Schaltungsanordnung (1) nach einem der Ansprüche 4 bis 5, wobei das Stromerkennungsmittel (2) als ein Optokoppler und der Wechselstromschalter (T2) als ein Triac/Thyristor ausgestaltet ist, wobei der Steuerausgang (S) an einen Steuereingang (20) eines Foto-Triacs (T1), der erste Anschluss (11) an einer ersten Hauptelektrode (21) des Foto-Triacs (T1), ein erster Anschluss (31) des Optokopplers an einer zweiten Hauptelektrode (22) des Foto-Triacs (T1) und ein zweiter Anschluss (32) des Optokopplers an den Steuereingang (G) angeschlossen ist.

8. Ausgabebaugruppe (50) für die industrielle Prozessautomatisierung zur Ausgabe einer einstellbaren Ausgabespannung für eine Last (L), aufweisend eine Schaltungsanordnung (1) nach einem der Ansprüche 4 bis 7.

9. Ausgabebaugruppe (50) nach Anspruch 8, wobei Mittel vorhanden sind die das Vorliegen eines Drahtbruchs an ein übergeordnetes Automatisierungssystem (51) weiterleiten, dabei ist das Steuermittel (MK) weiterhin dazu ausgestaltet das Ansteuern des Steuerausgangs (S) und das Vorhandensein eines Nulldurchgangs am ersten Eingang (E1) unter Auswertung des Detektionseingangs (15) dahingehend auszuwerten, dass bei Ausbleiben eines Signals am Detektionseingang (15) ein Drahtbruch in einer Anschlussleitung zur Last (L) vorliegt.
